# EUROPEAN PATENT APPLICATION

(11) **EP 4 753 395 A1**
(43) Date of publication of application: **03.06.2026**
(21) Application number: 25198008.2
(22) Date of filing: 26.08.2025
(51) Int. Cl.: H10B 43/27, H10B 43/30

(54) **SEMICONDUCTOR MEMORY DEVICE AND METHOD FOR MANUFACTURING SEMICONDUCTOR MEMORY DEVICE**

(30) Priority: 28.11.2024 JP 2024206940
(71) Applicant: Kioxia Corporation, Tokyo 108-0023 (JP)
(72) Inventor: MIYACHI, Katsunori, Minato-ku, Tokyo (JP)
(74) Representative: Hoffmann Eitle

(57) **Abstract**

A semiconductor memory device (1) of an embodiment includes: a plate-like portion (LI) that extends in a stacked body (LM) in a first direction intersecting a stacking direction of the stacked body (LM) and the stacking direction; a pillar (PL) that is disposed adjacent to the plate-like portion (LI) in the second direction and includes a semiconductor layer (CN) extending in the stacked body (LM) in the stacking direction; a first layer (DSLb) that is disposed above the stacked body (LM) and includes a semiconductor as a main component; and a second layer (ASL) that is disposed above the first layer (DSLb) and includes a semiconductor as a main component, wherein the plate-like portion (LI) includes a protrusion portion penetrating the first layer (DSLb) and extending upward, and the protrusion portion is covered with a third layer (DSLa) disposed between the first and second layers (DSLb, ASL) and including a semiconductor as a main component.

## Description

### CROSS-REFERENCE TO RELATED APPLICATIONS

This application is based upon and claims the benefit of priority from Japanese Patent Application No. 2024-206940, filed on November 28, 2024; the entire contents of which are incorporated herein by reference.

### FIELD

Embodiments described herein relate generally to a semiconductor memory device and a method for manufacturing the semiconductor memory device.

### BACKGROUND

In a semiconductor memory device such as a three-dimensional nonvolatile memory, a pillar penetrating a stacked body in which a plurality of conductive layers and a plurality of insulating layers are alternately stacked is formed. At that time, in order to crystallize a channel layer of the pillar and activate impurities in the channel layer, laser light or the like may be emitted from above a semiconductor memory device. However, the crystallization of the channel may not be sufficient around the pillar adjacent to another member or the like.

### BRIEF DESCRIPTION OF THE DRAWINGS

Figs. 1A and 1B are views illustrating a schematic configuration example of a semiconductor memory device according to an embodiment;
Figs. 2A to 2C are cross-sectional views illustrating an example of a configuration of the semiconductor memory device according to the embodiment;
Figs. 3A to 3C are views sequentially illustrating a part of a procedure of a method for manufacturing the semiconductor memory device according to the embodiment;
Figs. 4A and 4B are views sequentially illustrating a part of the procedure of the method for manufacturing the semiconductor memory device according to the embodiment;
Figs. 5A and 5B are views sequentially illustrating a part of the procedure of the method for manufacturing the semiconductor memory device according to the embodiment;
Figs. 6A and 6B are views sequentially illustrating a part of the procedure of the method for manufacturing the semiconductor memory device according to the embodiment;
Figs. 7A and 7B are views sequentially illustrating a part of the procedure of the method for manufacturing the semiconductor memory device according to the embodiment;
Figs. 8A and 8B are views sequentially illustrating a part of the procedure of the method for manufacturing the semiconductor memory device according to the embodiment;
Figs. 9A and 9B are views sequentially illustrating a part of the procedure of the method for manufacturing the semiconductor memory device according to the embodiment;
Figs. 10A and 10B are views sequentially illustrating a part of the procedure of the method for manufacturing the semiconductor memory device according to the embodiment;
Figs. 11A to 11D are views sequentially illustrating a part of the procedure of the method for manufacturing the semiconductor memory device according to the embodiment;
Figs. 12A to 12D are views sequentially illustrating a part of the procedure of the method for manufacturing the semiconductor memory device according to the embodiment;
Figs. 13A to 13D are views illustrating a method for doping impurities into a channel layer of a semiconductor memory device according to a comparative example; and
Figs. 14A to 14C are views illustrating a method for doping impurities into the channel layer of the semiconductor memory device according to the comparative example.

### DETAILED DESCRIPTION

A semiconductor memory device of an embodiment includes: a stacked body in which a plurality of conductive layers and a plurality of first insulating layers are alternately stacked one by one; a plate-like portion that extends in the stacked body in a first direction intersecting a stacking direction of the stacked body and the stacking direction, and divides the stacked body in a second direction intersecting the first direction and the stacking direction; a pillar that is disposed adjacent to the plate-like portion in the second direction and includes a semiconductor layer extending in the stacked body in the stacking direction; a first layer that is disposed above the stacked body and includes a semiconductor as a main component; and a second layer that is disposed above the first layer and includes a semiconductor as a main component, wherein the plate-like portion includes a protrusion portion penetrating the first layer and extending upward, and the protrusion portion is covered with a third layer disposed between the first and second layers and including a semiconductor as a main component.

Hereinafter, an embodiment of the present invention will be described in detail with reference to the drawings. Note that the present invention is not limited by the embodiment described below. In addition, constituent elements in the embodiment described below include those that can be easily assumed by those skilled in the art or those that are substantially the same.

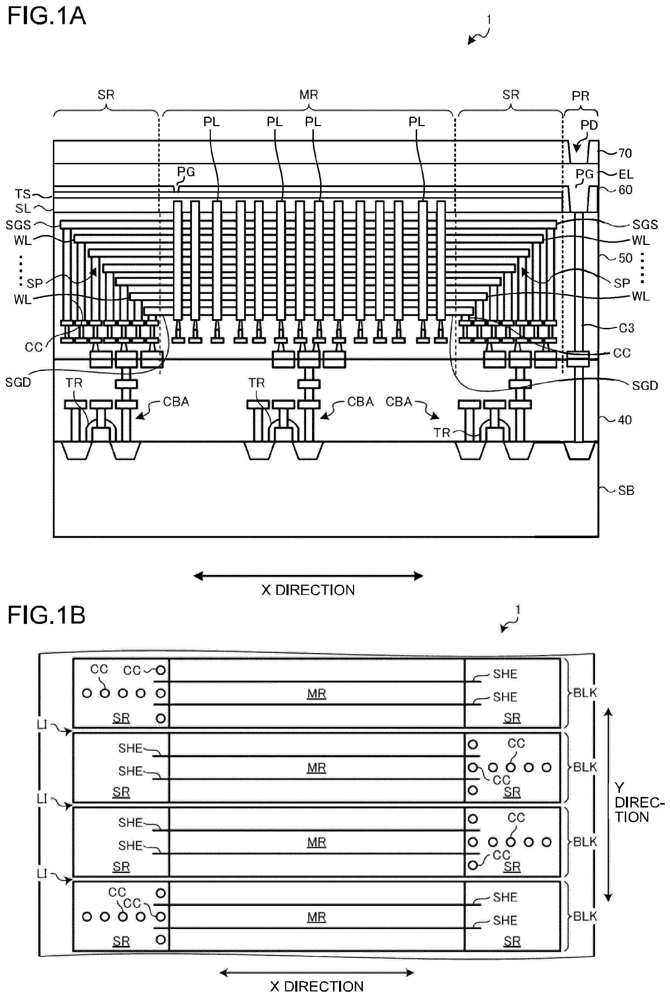

(Configuration Example of Semiconductor Memory Device) Figs. 1A and 1B are views illustrating a schematic configuration example of a semiconductor memory device 1 according to the embodiment. More specifically, Fig. 1A is a cross-sectional view of the semiconductor memory device 1 along an X direction, and Fig. 1B is a schematic plan view illustrating a layout of the semiconductor memory device 1.

However, in Fig. 1A, hatching is omitted in consideration of visibility of the drawing. In addition, in Fig. 1A, configurations that do not necessarily exist in the same cross section are illustrated, and a part of upper layer wiring and the like is omitted.

In addition, in the present specification, both the X direction and a Y direction are directions along the orientation of surfaces of word lines WL, and the X direction and the Y direction are orthogonal to each other. In addition, the electrical lead-out direction of the word lines WL may be referred to as a first direction, and the first direction is a direction along the X direction. In addition, a direction intersecting the first direction may be referred to as a second direction, and the second direction is a direction along the Y direction. However, since the semiconductor memory device 1 may include a manufacturing error, the first direction and the second direction are not necessarily orthogonal to each other.

As illustrated in Fig. 1A, the semiconductor memory device 1 includes a semiconductor substrate SB, peripheral circuits CBA, one or more select gate lines SGD, a plurality of word lines WL, one or more select gate lines SGS, a source line SL, and an electrode film EL in order from the lower side of the drawing.

The semiconductor substrate SB is, for example, a silicon substrate. The peripheral circuits CBA including transistors TR, wiring, and the like are disposed on the surface of the semiconductor substrate SB, and are entirely covered with an insulating layer 40. Above the semiconductor substrate SB on which the peripheral circuits CBA and the like are disposed, the plurality of word lines WL and the select gate lines SGD and SGS entirely covered with an insulating layer 50 are disposed.

As illustrated in Figs. 1A and 1B, a memory region MR is disposed at a central portion of the plurality of word lines WL and the like in the X direction, and staircase regions SR are disposed at both end portions of the plurality of word lines WL and the like in the X direction. The memory region MR and the staircase regions SR are divided into a plurality of regions by a plurality of plate-like contacts LI penetrating the plurality of word lines WL and the like and extending in the direction along the X direction.

Note that regions disposed between the plate-like contacts LI adjacent in the Y direction and including the memory region MR and the staircase regions SR are referred to as block regions BLK. As will be described below, the memory region MR includes a plurality of memory cells that holds data in a nonvolatile manner, and the above-described block region BLK is an erase unit of the data.

In addition, between the plate-like contacts LI adjacent in the Y direction, a plurality of separation layers SHE penetrating the select gate lines SGD and extending in the direction along the X direction is disposed. The plurality of separation layers SHE extends in the direction along the X direction over the entire memory region MR and reaches a part of the staircase regions SR at both end portions in the X direction.

In the memory region MR, a plurality of pillars PL is disposed. The plurality of pillars PL penetrates the plurality of word lines WL and the select gate lines SGD and SGS, and one end portion of each of the plurality of pillars PL protrudes into the source line SL.

The electrode film EL is disposed above a metal layer TS with an insulating layer 60 interposed therebetween. The entire electrode film EL except for a pad region PD provided in a peripheral region PR located on an outer side of the word lines WL and the like in the X direction is covered with an insulating layer 70. The insulating layer 70 has a configuration in which, for example, a silicon oxide layer, a silicon nitride layer, a polyimide layer, and the like are stacked from the lower layer side.

The electrode film EL is connected to the source line SL, a through-contact C3, and the like by a plug PG or the like penetrating the insulating layer 60. The through-contact C3 is provided in the peripheral region PR, penetrates the insulating layer 50 covering the word lines WL and the like and the insulating layer 40 covering the peripheral circuits CBA, and is connected to the semiconductor substrate SB on which the peripheral circuits CBA are disposed.

From the outside of the semiconductor memory device 1, the semiconductor substrate SB is controlled to a predetermined potential via the pad region PD and the through-contact C3. In addition, power and a signal from the outside are supplied from the pad region PD to the semiconductor memory device 1.

A plurality of memory cells is formed at intersection portions of the pillars PL and the word lines WL. As a result, the semiconductor memory device 1 is configured as, for example, a three-dimensional nonvolatile memory in which memory cells are three-dimensionally disposed in the memory region MR.

In the staircase regions SR, staircase portions SP in which the plurality of word lines WL and the select gate lines SGD and SGS are processed into a staircase shape and terminated are disposed. The separation layers SHE described above extend from the memory region MR to a portion of the staircase regions SR where the select gate lines SGD are processed into a staircase shape. As a result, in one block region BLK, the select gate lines SGD are separated into a plurality of regions. In other words, the separation layers SHE penetrate the portions below the plurality of word lines WL, so that these portions are partitioned into patterns of the plurality of select gate lines SGD.

Contacts CC extending upward in the insulating layer 50 and connected to the word lines WL and the select gate lines SGD and SGS of layers are disposed at terrace portions of steps including the plurality of word lines WL and the select gate lines SGD and SGS.

Note that, in the present specification, the direction in which the terrace surfaces of the plurality of word lines WL and the select gate lines SGD and SGS face is defined as the lower side of the semiconductor memory device 1.

In the word lines WL and the select gate lines SGS, one contact CC is connected for each layer. In the select gate lines SGD, one contact CC is connected for each section separated by the separation layers SHE per layer.

Here, in one block region BLK, the plurality of contacts CC is disposed on one of the staircase regions SR on both sides in the X direction. In addition, when viewed on one side in the X direction, for example, the plurality of contacts CC is disposed every two block regions BLK.

That is, in the example of Fig. 1B, in the uppermost block region BLK in the drawing, a plurality of contacts CC is disposed, for example, in the staircase region SR on the left side in the drawing out of the staircase regions SR at both end portions in the X direction. In addition, in the block regions BLK one below and two below the above-described block region BLK, a plurality of contacts CC is disposed in the staircase region SR on the right side in the drawing out of the staircase regions SR at both end portions in the X direction. Further, in the lowermost block region BLK in the drawing, a plurality of contacts CC is disposed in the staircase region SR again on the left side in the drawing.

Accordingly, the contacts CC of the staircase regions SR at both end portions in the X direction illustrated in Fig. 1A belong to different block regions BLK, and are not actually located in the same cross section.

The word lines WL and the like stacked in multiple layers are individually led out by these contacts CC. More specifically, a write voltage, a read voltage, and the like are applied from these contacts CC to the memory cells included in the memory region MR at the central portion of the plurality of word lines WL via the word lines WL at the same height positions as the memory cells.

Note that the semiconductor memory device 1 of the embodiment is configured by bonding the insulating layer 40 covering the peripheral circuits CBA and the insulating layer 50 covering the word lines WL and the like to each other. In this manner, the insulating layers 40 and 50 function as bonding layers. In addition, by bonding the insulating layers 40 and 50, electrode pads disposed on the surfaces of the insulating layers 40 and 50 are connected to each other, so that the peripheral circuits CBA are electrically connected to the contacts CC, the plurality of word lines WL, the select gate lines SGS and SGD, and the pillars PL.

The application of a predetermined voltage from the contacts CC to the memory cells is controlled by the peripheral circuits CBA electrically connected to these configurations. In this manner, the peripheral circuits CBA control the electrical operation of the memory cells.

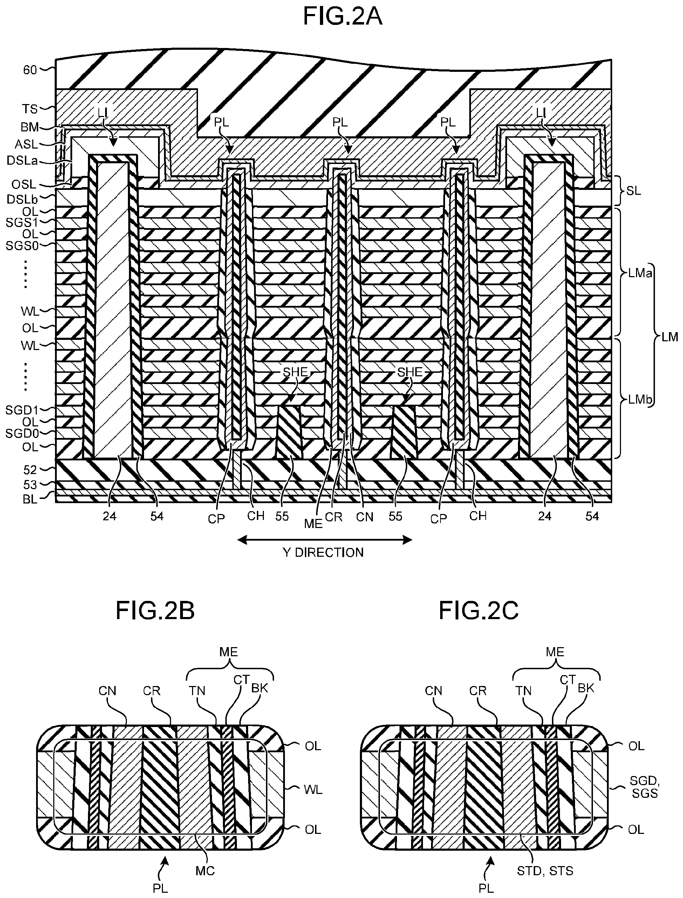

Next, a detailed configuration example of the semiconductor memory device 1 will be described with reference to Figs. 2A to 2C. Figs. 2A to 2C are cross-sectional views illustrating an example of a configuration of the semiconductor memory device 1 according to the embodiment.

More specifically, Fig. 2A is a cross-sectional view along the Y direction of the memory region MR of the semiconductor memory device 1. In Fig. 2A, structures above the insulating layer 60 and below an insulating layer 52 described below are omitted.

Fig. 2B is an enlarged cross-sectional view of the pillar PL at the height position of the word line WL. Fig. 2C is an enlarged cross-sectional view of the pillar PL at the height position of the select gate line SGD or SGS.

As illustrated in Fig. 2A, the metal layer TS, a barrier metal layer BM, and the source line SL are disposed below the insulating layer 60 in order from the insulating layer 60 side.

The insulating layer 60 is, for example, a silicon oxide layer or the like. The metal layer TS is, for example, a tungsten layer or the like, and functions as a source line metal of the semiconductor memory device 1 in addition to the source line SL below. The barrier metal layer BM is, for example, at least one of a titanium layer, a titanium nitride layer, a tantalum layer, or a tantalum nitride layer, and suppresses diffusion of tungsten atoms from the metal layer TS to a nearby configuration.

The source line SL has a multilayer structure in which, for example, an auxiliary source line ASL and a main source line DSLb are disposed in this order downward from the barrier metal layer BM side. The auxiliary source line ASL is, for example, a non-doped amorphous layer, a non-doped polysilicon layer, or a non-doped semiconductor layer in which an amorphous layer and a polysilicon layer are mixed. The main source line DSLb is, for example, a polycrystalline semiconductor layer such as a non-doped polysilicon layer or an amorphous semiconductor layer such as a non-doped amorphous silicon layer. However, at least one of the auxiliary source line ASL and the main source line DSLb may include impurities that become N-type conductive, such as phosphorus or arsenic.

Note that the source line SL may include a stopper layer DSLa described below. The stopper layer DSLa is, for example, a polycrystalline semiconductor layer such as a polysilicon layer including N-type impurities such as phosphorus or arsenic.

A stacked body LM in which the plurality of word lines WL and a plurality of insulating layers OL are alternately stacked one by one is disposed below the source line SL. The stacked body LM is configured to include a stacked body LMa disposed below the source line SL and a stacked body LMb disposed further below the stacked body LMa.

The stacked body LMa includes select gate lines SGS1 and SGS0 in order from the source line SL side further above the uppermost word line WL. These select gate lines SGS1 and SGS0 are source-side select gate lines.

The stacked body LMb includes select gate lines SGD1 and SGD0 in order from the lowermost word line WL side further below the lowermost word line WL. These select gate lines SGD1 and SGD0 are drain-side select gate lines.

However, the number of word lines WL and select gate lines SGS and SGD included in the stacked body LM is arbitrary. Accordingly, the stacked body LM may include one or three or more select gate lines SGS and SGD. The plurality of word lines WL and the select gate lines SGS and SGD are, for example, tungsten layers or molybdenum layers, and the plurality of insulating layers OL is, for example, silicon oxide layers.

Insulating layers 52 and 53 are disposed in order from the stacked body LM side below the stacked body LM. These insulating layers 52 and 53 constitute a part of the above-described insulating layer 50 (see Fig. 1A).

As described above, the plurality of plate-like contacts LI extends in the stacking direction of the stacked body LM and the direction along the X direction. More specifically, the plate-like contacts LI penetrate the stacked body LM and the main source line DSLb, and protrude into the stopper layer DSLa interposed between the main source line DSLb and the auxiliary source line ASL.

The stopper layer DSLa is unevenly distributed in the vicinity of the plate-like contacts LI, is disposed on the main source line DSLb via an intermediate insulating layer OSL, and covers upper end portions of the plate-like contacts LI. The plate-like contacts LI also penetrate the intermediate insulating layer OSL. The intermediate insulating layer OSL is, for example, a silicon oxide layer or the like.

Each of these plate-like contacts LI includes a conductive layer 24 such as a tungsten layer and an insulating layer 54 covering a sidewall of the conductive layer 24. The insulating layer 54 also covers an upper end portion of the conductive layer 24 protruding into the stopper layer DSLa.

However, as described above, each of the main source line DSLb, the stopper layer DSLa, and the auxiliary source line ASL is a semiconductor layer such as a silicon layer. Accordingly, in the actual semiconductor memory device 1, interfaces and the like of the main source line DSLb, the stopper layer DSLa, and the auxiliary source line ASL cannot be distinguished, and these layers may not be able to be individually identified.

Even in such a case, it can be identified that, among the various semiconductor layers described above, the semiconductor layer disposed on the upper end portions of the pillars PL is the thin auxiliary source line ASL, whereas the relatively thick semiconductor layers of the stopper layer DSLa and the auxiliary source line ASL are disposed on the upper end portions of the plate-like contacts LI. In addition, since the main source line DSLb and the stopper layer DSLa are layers of different materials, it is possible to determine that the intermediate insulating layer OSL is interposed therebetween, and thus, it is possible to distinguish between the main source line DSLb and the stopper layer DSLa. Furthermore, while the main source line DSLb and the auxiliary source line ASL are non-doped semiconductor layers, the stopper layer DSLa covering the upper end portions of the plate-like contacts LI includes N-type impurities. Even when the main source line DSLb and the auxiliary source line ASL include N-type impurities, they can be distinguished from the stopper layer DSLa because the crystallinity varies depending on how heat is applied in the manufacturing process, or the type or concentration of impurities varies.

From the above, it is considered that it can be identified that the upper end portions of the pillars PL are not covered with the stopper layer DSLa, whereas the upper end portions of the plate-like contacts LI are covered with the stopper layer DSLa.

In addition, the plate-like contacts LI have, for example, a tapered shape in which the width in the Y direction increases from the upper end portion toward the lower end portion. Alternatively, the plate-like contacts LI have, for example, a bowing shape in which the width in the Y direction is maximized at a predetermined position between the upper end portion and the lower end portion.

Between the plate-like contacts LI adjacent in the Y direction among the plurality of plate-like contacts LI, one or more separation layers SHE, which are insulating layers 55 such as silicon oxide layers, for example, extend in a lower layer portion of the stacked body LM in the direction along the X direction. In the example of Fig. 2A, the separation layers SHE penetrate the select gate lines SGD0 and SGD1 described above and reach the insulating layer OL adjacent to the select gate line SGD1 in the stacking direction. As a result, the select gate lines SGD0 and SGD1 are divided into a plurality of sections.

In addition, between the plate-like contacts LI adjacent in the Y direction, the plurality of pillars PL extends in the stacked body LM in the stacking direction of the stacked body LM. More specifically, these pillars PL extend in the stacked body LM in the stacking direction of the stacked body LM from the lowermost insulating layer OL of the stacked body LM, and penetrate the stacked body LM and the main source line DSLb.

The plurality of pillars PL is disposed, for example, in a staggered manner when viewed in the stacking direction of the stacked body LM. Individual pillar PL has, for example, a circular shape, an elliptical shape, an oblong shape (oval shape), or the like as a cross-sectional shape in a direction along the layering direction of the stacked body LM, that is, in a direction along the XY plane.

In addition, each of the pillars PL has a tapered shape in which the diameter and the cross-sectional area increase from the upper layer side toward the lower layer side in a portion penetrating the stacked body LMa and a portion penetrating the stacked body LMb. Alternatively, each of the pillars PL has, for example, a bowing shape in which the diameter and the cross-sectional area are maximized at a predetermined position between the upper layer side and the lower layer side in a portion penetrating the stacked body LMa and a portion penetrating the stacked body LMb.

In addition, the pillar PL includes a core layer CR serving as a core material, a channel layer CN covering a sidewall of the core layer CR, a memory layer ME covering a sidewall of the channel layer CN, and a cap layer CP disposed at a lower end portion of the pillar PL.

Among the core layer CR, the channel layer CN, and the memory layer ME, the memory layer ME penetrates the stacked body LM and the main source line DSLb and reaches the auxiliary source line ASL. In addition, the core layer CR and the channel layer CN penetrate the stacked body LM and the main source line DSLb, and upper end portions thereof protrude into the metal layer TS. The upper end portion of the channel layer CN in the metal layer TS is covered with the auxiliary source line ASL and the barrier metal layer BM in this order.

That is, the portion of the channel layer CN protruding into the metal layer TS is not covered with the memory layer ME, and the channel layer CN is in direct contact with the auxiliary source line ASL. Thus, the channel layer CN is electrically connected to the main source line DSLb via the auxiliary source line ASL. N-type impurities such as phosphorus and arsenic are contained in the channel layer CN from the upper end portion connected to the auxiliary source line ASL and the like to depth positions of the select gate lines SGS0 and SGS1 described above.

Note that the stopper layer DSLa and the intermediate insulating layer OSL described above are unevenly distributed in the vicinity of the plate-like contacts LI, and are not disposed in the vicinity of the pillars PL.

The cap layers CP disposed at the lower end portions of the pillars PL connect the channel layers CN and plugs CH extending to penetrate the lowermost insulating layer OL of the stacked body LM and the insulating layer 52 therebelow. The plugs CH connect a bit line BL disposed in the insulating layer 53 and the pillars PL disposed in the stacked body LM. The bit line BL extends below the stacked body LM in the direction along the Y direction so as to intersect with the lead-out direction of the word lines WL.

As illustrated in Figs. 2B and 2C, the memory layer ME has a stacked structure including a block insulating layer BK, a charge storage layer CT, and a tunnel insulating layer TN in order from an outer peripheral side of the pillar PL. The charge storage layer CT of the memory layer ME is, for example, a silicon nitride layer or the like. The block insulating layer BK and the tunnel insulating layer TN of the memory layer ME, and the core layer CR are, for example, silicon oxide layers or the like. The channel layer CN and the cap layer CP are polycrystalline semiconductor layers such as polysilicon layers or the like.

As illustrated in Fig. 2B, with the above configuration, a memory cell MC is formed in each portion facing the individual word lines WL on the side surface of the pillar PL. When a predetermined voltage is applied from the word line WL, data is written to and read from the memory cell MC.

As illustrated in Fig. 2C, a select gate STD is formed in a portion where the side surface of the pillar PL faces the select gate lines SGD0 and SGD1. In addition, a select gate STS is formed in a portion where the side surface of the pillar PL faces the select gate lines SGS0 and SGS1 below the word lines WL.

When predetermined voltages are applied from the select gate lines SGD and SGS, the select gates STD and STS are turned on or off, and the memory cells MC of the pillar PL to which the select gate STD or STS belong can be brought into a selected state or a non-selected state. As described above, impurities such as phosphorus or arsenic are contained in the channel layer CN at the depth positions of the select gate lines SGD and SGS, so that a threshold voltage of the select gate STS can be adjusted to a desired value.

### (Method for Manufacturing Semiconductor Memory Device)

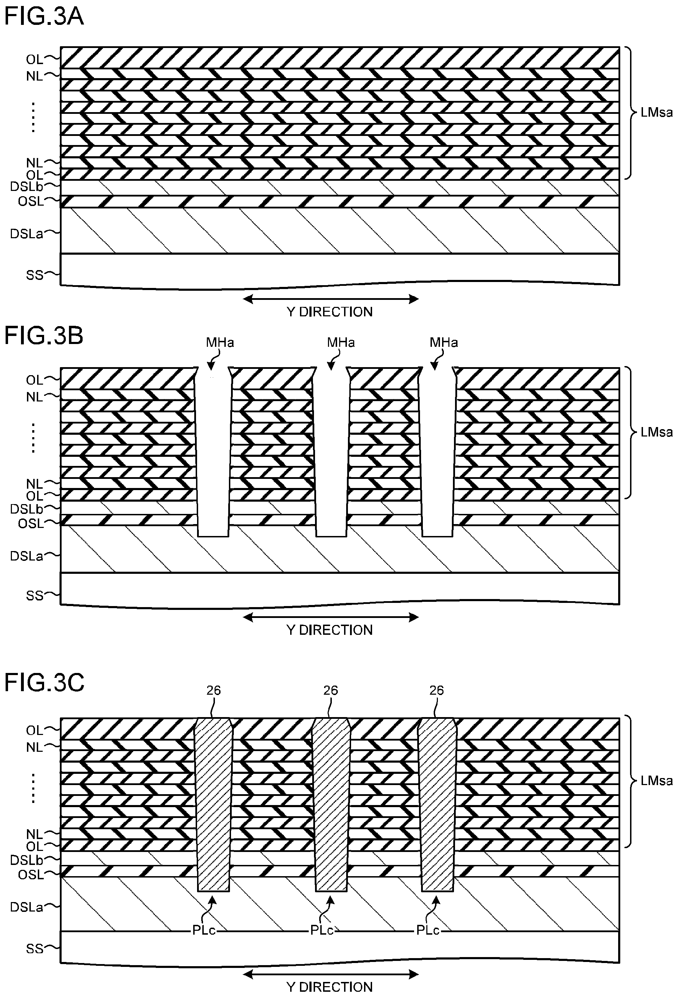

Next, a method for manufacturing the semiconductor memory device 1 of the embodiment will be described with reference to Figs. 3A to 12D. Figs. 3A to 12D are views sequentially illustrating a part of the procedure of the method for manufacturing the semiconductor memory device 1 according to the embodiment. More specifically, Figs. 3A to 12D illustrate a cross-section along the Y direction of a region that becomes the memory region MR later.

Note that, in the following description, a direction in which a surface of a support substrate SS, which will be described below, or the semiconductor substrate SB on a side on which various types of treatment are performed faces is defined as an upper side of the semiconductor memory device 1 in the middle of manufacturing. In other words, the upper side of the drawing of the following drawings is the upper side of the semiconductor memory device 1 in the middle of manufacturing, and the lower side of the drawing is the lower side of the semiconductor memory device 1 in the middle of manufacturing.

As illustrated in Fig. 3A, the support substrate SS is prepared. As the support substrate SS, a semiconductor substrate such as a silicon substrate, an insulating substrate such as a ceramic substrate, a conductive substrate, or the like can be used.

Hereinafter, formation steps of forming the configuration to be the source line SL later, the stacked body LM, the pillars PL, and the like on the upper surface of the support substrate SS are performed in a state where an up-down direction is inverted with respect to the examples of Figs. 1A and 2A to 2C described above.

First, the stopper layer DSLa, the intermediate insulating layer OSL, and the main source line DSLb are formed in this order on the support substrate SS. The stopper layer DSLa and the main source line DSLb are polycrystalline semiconductor layers such as non-doped polysilicon layers. At this time, the stopper layer DSLa and the main source line DSLb may be formed as amorphous silicon layers. The intermediate insulating layer OSL is a silicon oxide layer or the like.

In addition, a stacked body LMsa in which a plurality of insulating layers NL and the plurality of insulating layers OL are alternately stacked one by one is formed on the main source line DSLb. The insulating layers NL are, for example, silicon nitride layers or the like, and function as sacrificial layers that are later replaced with conductive materials and become the word lines WL or the select gate lines SGS.

Thereafter, although not illustrated, the insulating layers NL and the insulating layers OL are processed into a staircase shape in a partial region of the stacked body LMsa. Such processing can be performed by repeating slimming of a mask pattern such as a photoresist layer and etching of the insulating layers NL and the insulating layers OL of the stacked body LMsa a plurality of times.

That is, a mask pattern is formed on the upper surface of the stacked body LMsa, and the insulating layer NL and the insulating layer OL in an exposed portion are etched away one by one. In addition, an end portion of the mask pattern is retracted by treatment with oxygen plasma or the like to newly expose the upper surface of the stacked body LMsa, and the insulating layer NL and the insulating layer OL are further etched away one by one. By repeating such treatment a plurality of times, the stacked body LMsa having a staircase shape is formed at both end portions in the X direction.

Thereafter, the staircase shape at both end portions in the X direction is covered with a part of the above-described insulating layer 50 (see Fig. 1A).

As illustrated in Fig. 3B, a plurality of memory holes MHa extending through the stacked body LMsa in the stacking direction is formed. The plurality of memory holes MHa penetrates the stacked body LMsa, the main source line DSLb, and the intermediate insulating layer OSL, and reaches a predetermined depth of the stopper layer DSLa. These memory holes MHa are portions that later become portions of the pillars PL that penetrate the stacked body LMa.

As illustrated in Fig. 3C, the memory holes MHa are filled with sacrificial layers 26 such as CVD-carbon layers. As a result, pillars PLc in which the plurality of memory holes MHa is filled with the sacrificial layers 26 are formed.

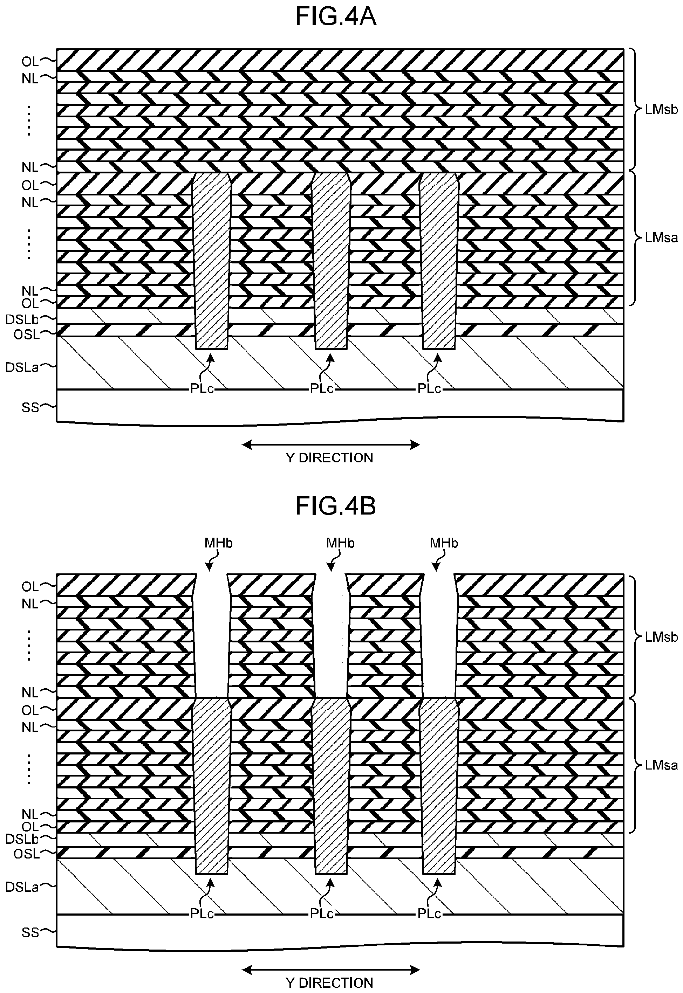

As illustrated in Fig. 4A, a stacked body LMsb that covers the stacked body LMsa and in which the plurality of insulating layers NL and the plurality of insulating layers OL are alternately stacked one by one is formed. The insulating layers NL of the stacked body LMsb function as sacrificial layers that are later replaced with conductive layers and become the word lines WL or the select gate lines SGD.

Thereafter, although not illustrated, the insulating layers NL and the insulating layers OL are processed into a staircase shape in a partial region of the stacked body LMsb. Such processing can be performed by repeating slimming of a mask pattern such as a photoresist layer and etching of the insulating layers NL and the insulating layers OL of the stacked body LMsb a plurality of times similarly to the treatment on the stacked body LMsa described above.

At this time, the uppermost step of the stair part formed in the stacked body LMsa and the lowermost step of the stair part formed in the stacked body LMsb are brought close to each other to form a staircase shape continuously from the lower layer side of the stacked body LMsa to the upper layer side of the stacked body LMsb. As a result, the stacked bodies LMsa and LMsb are formed in which the staircase regions SR having a staircase shape from the stacked body LMsa to the stacked body LMsb are formed at both end portions in the X direction.

Thereafter, the staircase shape at both end portions in the X direction is further covered with a part of the above-described insulating layer 50 (see Fig. 1A).

As illustrated in Fig. 4B, a plurality of memory holes MHb penetrating the stacked body LMsb and connected to the plurality of pillars PLc formed in the stacked body LMsa are formed. The memory holes MHb are portions that later become portions of the pillars PL that penetrate the stacked body LMb.

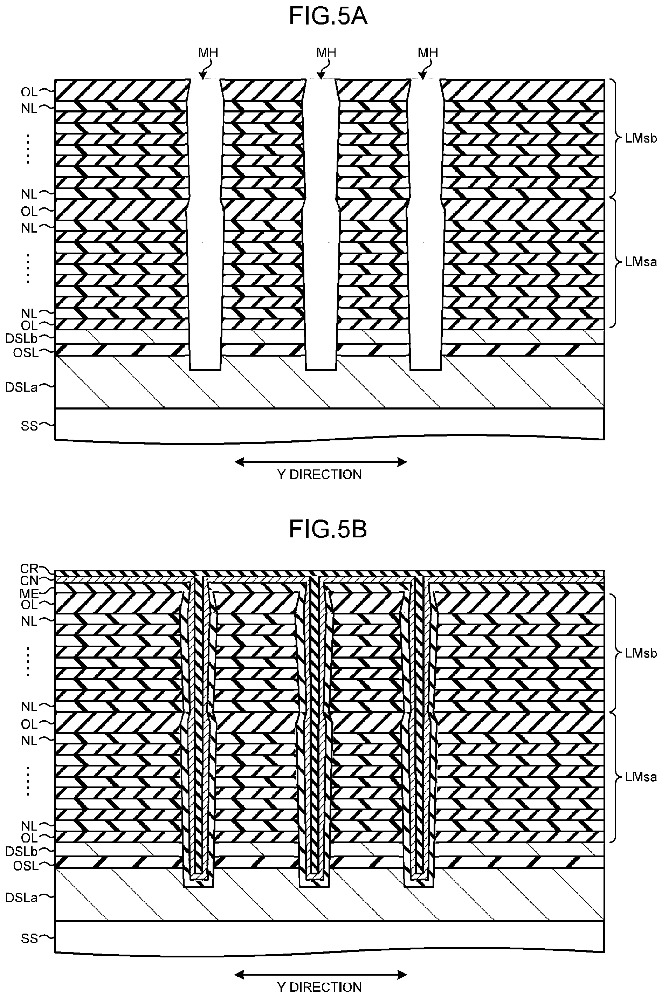

As illustrated in Fig. 5A, the sacrificial layers 26 are removed from the pillars PLc at the bottoms of the memory holes MHb. As a result, the memory holes MHa are opened at the bottoms of the plurality of memory holes MHb, and a plurality of memory holes MH penetrating the stacked bodies LMsb and LMsa, the main source line DSLb, and the intermediate insulating layer OSL and reaching the predetermined depth of the stopper layer DSLa is formed.

Note that, in a case where the sacrificial layers 26 loaded in the pillars PLc are CVD-carbon layers or the like, the sacrificial layers 26 can be collectively removed from these pillars PLc when the mask pattern or the like used at the time of forming the memory holes MHb in Fig. 4B described above is removed by ashing or the like using oxygen plasma.

As illustrated in Fig. 5B, the memory layer ME including the block insulating layer BK, the charge storage layer CT, and the tunnel insulating layer TN (see Figs. 2B and 2C) in this order from sidewall sides of the memory holes MH is formed on the sidewalls and the bottom surfaces of the memory holes MH. The memory layer ME is also formed on the upper surface of the stacked body LMsb.

In addition, the channel layer CN and the core layer CR are formed in this order in the memory hole MH via the memory layer ME. As a result, the channel layer CN is formed on the memory layer ME covering the side surface and the bottom surface of the memory hole MH, and the core layer CR is loaded in the central portion of the memory hole MH. The channel layer CN and the core layer CR are also formed in this order on the upper surface of the stacked body LMsb via the memory layer ME.

Note that the channel layer CN is not doped with impurities at this time point, and may be in an amorphous state such as an amorphous silicon layer.

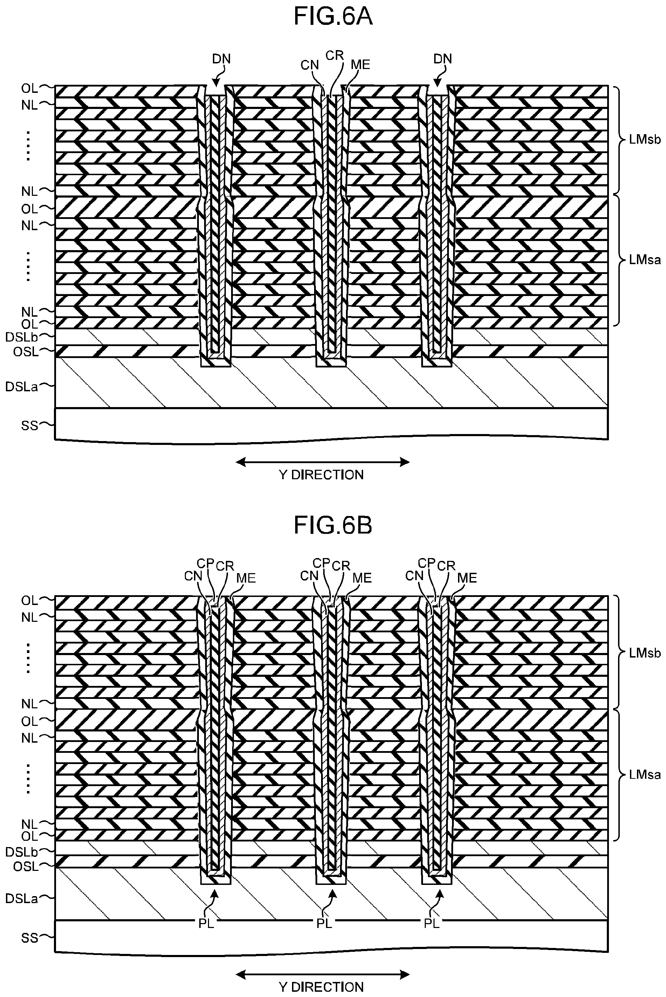

As illustrated in Fig. 6A, the core layers CR, the channel layers CN, and the memory layers ME formed on the upper surface of the stacked body LMsb are etched back and removed together with a part of the uppermost insulating layer OL of the stacked body LMsb, and the core layers CR are retracted to a predetermined depth of the memory holes MH to form recesses DN at the upper end portions of the memory holes MH.

As illustrated in Fig. 6B, the cap layers CP are formed in the recesses DN at the upper end portions of the memory holes MH. At this time point, the cap layers CP may be in an amorphous state such as amorphous silicon layers.

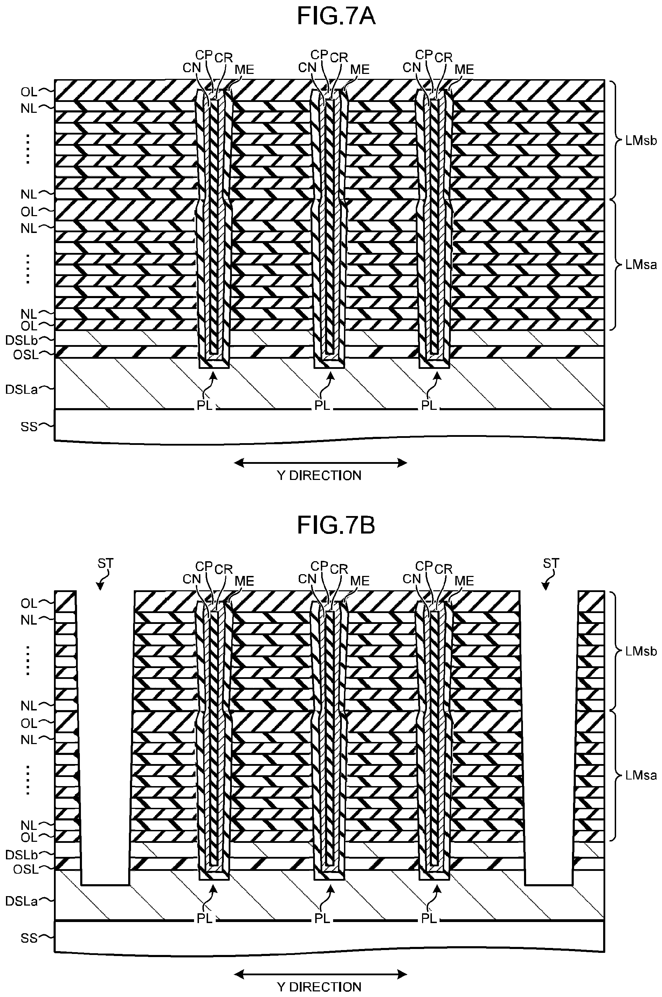

As illustrated in Fig. 7A, by etching back the core layers CR, the channel layers CN, the memory layers ME, and the like formed on the upper surface of the stacked body LMsb, the uppermost insulating layer OL of the stacked body LMb whose thickness has been reduced is stacked. As a result, the pillars PL in which the upper end portions are embedded in the uppermost insulating layer OL of the stacked body LMsb are formed. However, at this time point, the memory layers ME cover the channel layers CN at the lower end portions of the pillars PL.

As illustrated in Fig. 7B, slits ST that penetrate the stacked bodies LMsb and LMsa, the main source line DSLb, and the intermediate insulating layer OSL and reach a predetermined depth of the stopper layer DSLa are formed. The slits ST also extend in the direction along the X direction in the stacked bodies LMsa and LMsb.

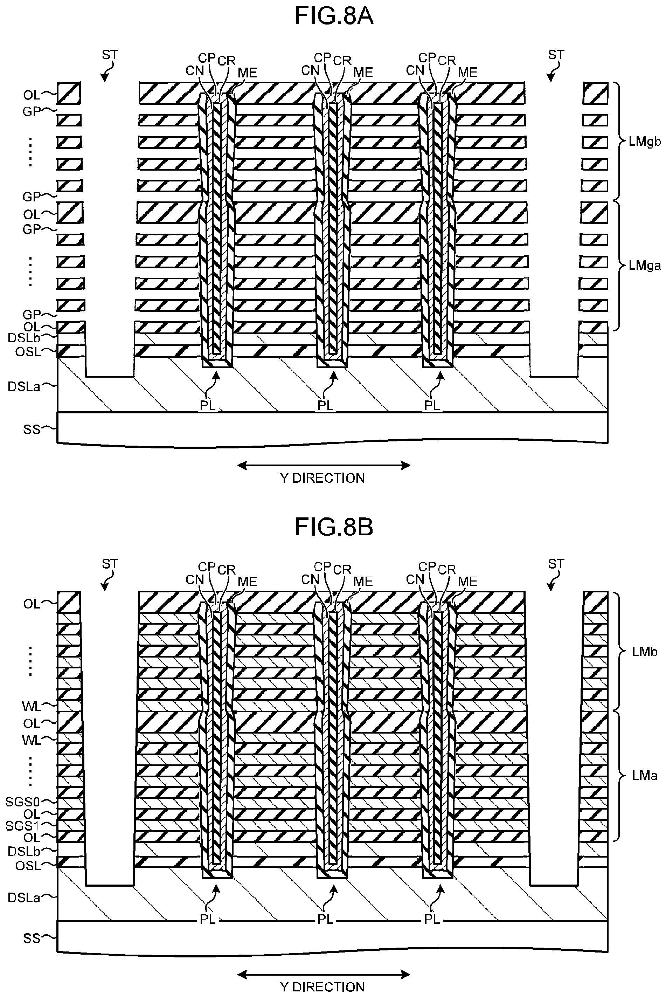

As illustrated in Fig. 8A, a removal liquid for the insulating layers NL such as, for example, hot phosphoric acid is caused to flow into the stacked bodies LMsa and LMsb from the slits ST to remove the insulating layers NL of the stacked bodies LMsa and LMsb. As a result, stacked bodies LMga and LMgb including a plurality of gap layers GP from which the insulating layers NL between the insulating layers OL are removed are formed.

The stacked bodies LMga and LMgb including the plurality of gap layers GP have a fragile structure. The plurality of pillars PL supports such fragile stacked bodies LMga and LMgb. As a result, bending of the insulating layers OL remaining in the stacked bodies LMga and LMgb and distortion or collapse of the stacked bodies LMga and LMgb are suppressed.

As illustrated in Fig. 8B, a source gas of a conductive material such as tungsten or molybdenum is injected from the slits ST into the stacked bodies LMga and LMgb, and the gap layers GP of the stacked bodies LMga and LMgb are filled with the conductive material to form the plurality of word lines WL and the like. As a result, the stacked body LM including stacked bodies LMa and LMb in which the plurality of word lines WL and the like and the plurality of insulating layers OL are alternately stacked one by one is formed.

As described above, the treatment of forming the word lines WL from the insulating layers NL is also referred to as a replacement treatment.

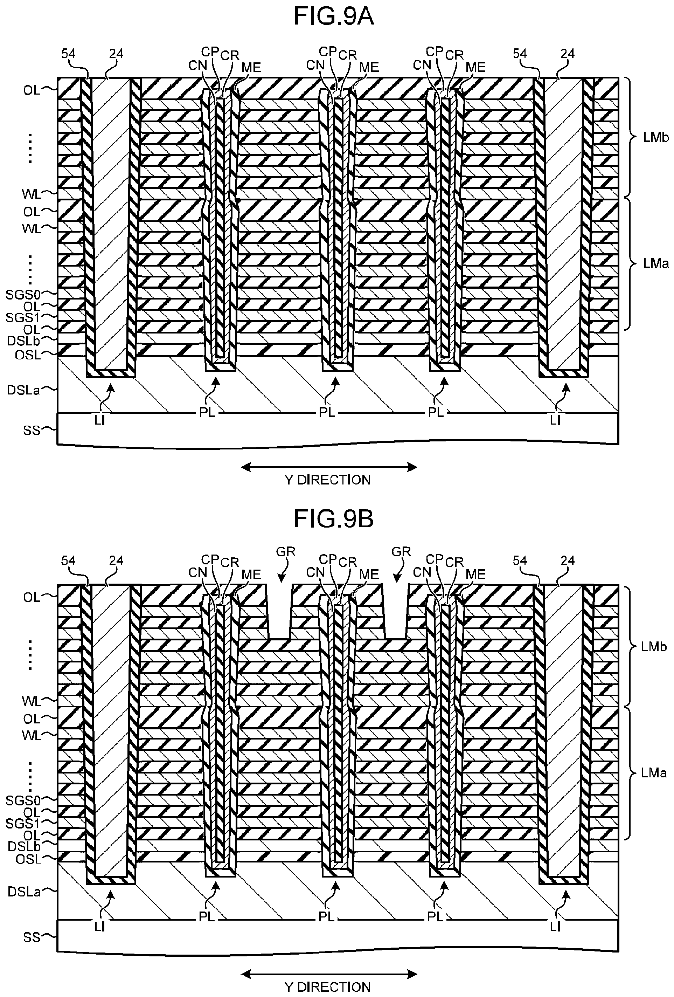

As illustrated in Fig. 9A, after the insulating layers 54 are formed in the slits ST, the conductive layers 24 are formed to form the plate-like contacts LI.

As illustrated in Fig. 9B, grooves GR penetrating one or a plurality of conductive layers including the uppermost conductive layer of the stacked body LMb are formed.

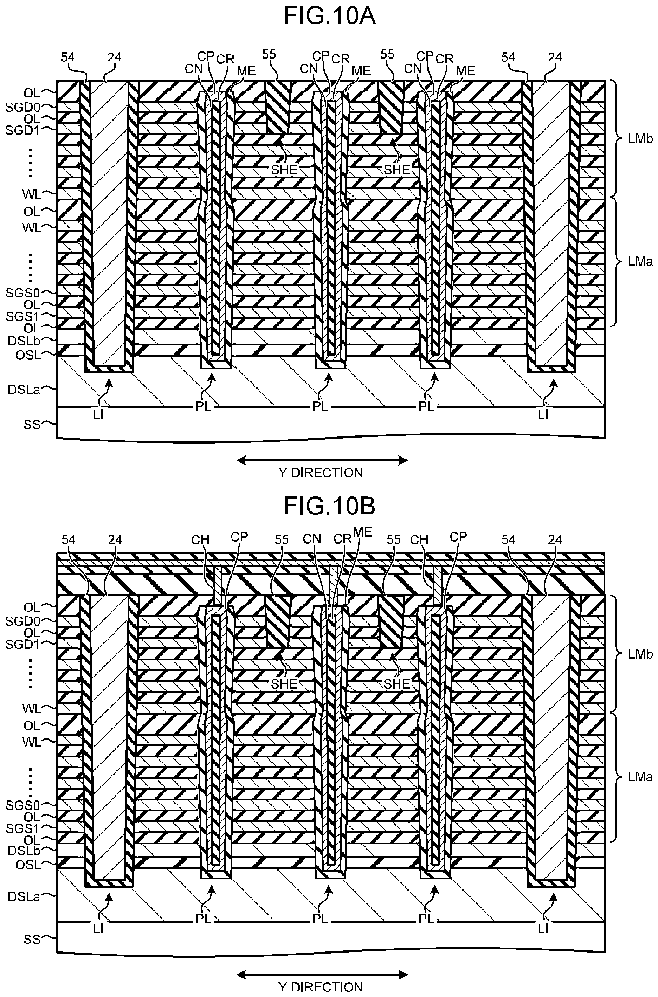

As illustrated in Fig. 10A, the insulating layers 55 are loaded in the grooves GR to form the separation layers SHE that partition the conductive layer on the upper layer side of the stacked body LM into the pattern of the select gate lines SGD.

In addition, although not illustrated, the plurality of contacts CC reaching the word lines WL and the select gate lines SGD and SGS constituting the steps of the staircase structure of the staircase regions SR are formed from the upper side of the staircase regions SR.

As illustrated in Fig. 10B, after the insulating layer 52 covering the stacked body LM are formed, the plugs CH penetrating the uppermost insulating layer OL of the stacked body LM and the insulating layer 52 and connected to the cap layers CP at the upper end portions of the pillars PL are formed. In addition, the insulating layer 53 covering the insulating layer 52 is formed, and the bit line BL to which the individual plugs CH are connected is formed in the insulating layer 53.

Note that, for example, the plugs CH, the bit line BL, and the like may be collectively formed by using a dual damascene method or the like.

In addition, although not illustrated, the peripheral circuits CBA are formed on the semiconductor substrate SB separate from the support substrate SS on which the stacked body LM is formed, and are covered with the insulating layer 40. In the insulating layer 40, contacts, vias, wiring, or the like that lead the peripheral circuits CBA to the surface of the insulating layer 40 are formed and connected to the electrode pad or the like formed on the upper surface of the insulating layer 40.

In addition, the support substrate SS and the semiconductor substrate SB are bonded to each other by the insulating layers 50 and 40, and the electrode pads in the insulating layers 50 and 40 are connected. These insulating layers 50 and 40 can be joined by being activated in advance by, for example, plasma treatment or the like. In addition, by performing an annealing treatment after the insulating layers 50 and 40 are bonded, the electrode pads in the insulating layers 50 and 40 can be connected by Cu-Cu joining or the like.

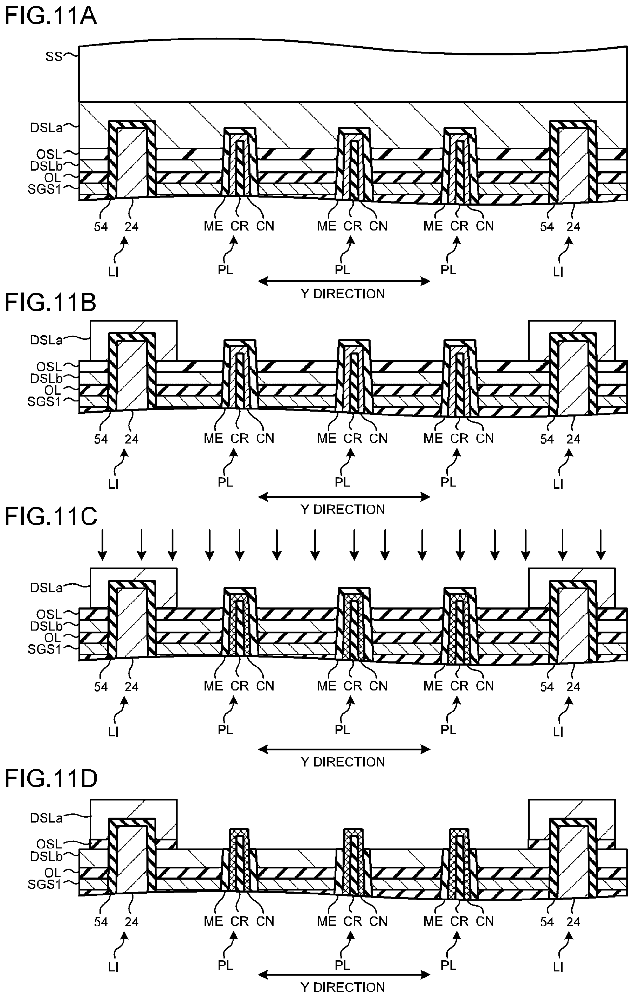

As illustrated in Fig. 11A, thereafter, various types of treatment are performed from the support substrate SS side that is bonded onto the semiconductor substrate SB upside down. Accordingly, in the following drawings, a state is illustrated in which various types of treatment are performed from the upper end portion side of the pillars PL and the plate-like contacts LI with the portions of the pillars PL and the plate-like contacts LI protruding into the stopper layer DSLa as the upper end portions.

Note that, in the drawings after Fig. 11A, only the upper end portions of the pillars PL and the plate-like contacts LI are illustrated.

As illustrated in Fig. 11B, the support substrate SS is removed by cleaving the interface between the stopper layer DSLa and the support substrate SS. In addition, in the memory region MR in which the pillars PL and the like are formed, the stopper layer DSLa is removed using the intermediate insulating layer OSL as a stopper layer. At this time, a photomask layer, which is not illustrated, or the like is formed on the stopper layer DSLa at a position overlapping the upper end portions of the plate-like contacts LI, and the stopper layer DSLa covering the upper end portions of the plate-like contacts LI is left without being removed.

As a result, in the memory region MR, the upper end portions of the pillars PL protrude above the intermediate insulating layer OSL. On the other hand, the upper end portions of the plate-like contacts LI are maintained in a state of being covered with the stopper layer DSLa.

As illustrated in Fig. 11C, implant treatment using phosphorus, arsenic, or the like is performed on the upper end portions of the pillars PL protruding above the intermediate insulating layer OSL, and the semiconductor layers CN of the pillars PL are doped with N-type impurities via the memory layers ME. By doping with these impurities, at least the upper end portions of the channel layers CN become amorphous semiconductor layers such as amorphous silicon layers.

On the other hand, the intermediate insulating layer OSL suppresses doping of the main source line DSLb with these impurities. However, by the above treatment, the stopper layer DSLa covering the upper end portions of the plate-like contacts LI may be doped with impurities, and the stopper layer DSLa may be changed from a polysilicon layer or the like to an amorphous silicon layer or the like. When the stopper layer DSLa is doped with impurities, the main source line DSLb may be further doped with impurities via the intermediate insulating layer OSL or the like. At this time, the impurity concentration of the stopper layer DSLa may be higher than the impurity concentration of the main source line DSLb. In addition, when the stopper layer DSLa is not doped with impurities, the impurity concentration of the stopper layer DSLa may be lower than the impurity concentration of the main source line DSLb. When the stopper layer DSLa is not doped with impurities and the main source line DSLb is not doped with impurities, both the stopper layer DSLa and the main source line DSLb are maintained as non-doped polysilicon layers or amorphous silicon layers.

As illustrated in Fig. 11D, the memory layers ME are removed from the upper end portions of the pillars PL protruding above the intermediate insulating layer OSL. In addition, in parallel with this, the intermediate insulating layer OSL is removed. As a result, the upper end portions of the channel layers CN of the pillars PL are exposed above the main source line DSLb. At this time, since the insulating layers 54 of the plate-like contacts LI are covered with the stopper layer DSLa, they remain without being removed. In addition, the intermediate insulating layer OSL that is interposed between the stopper layer DSLa and the main source line DSLb and through which the plate-like contacts LI penetrate also remains.

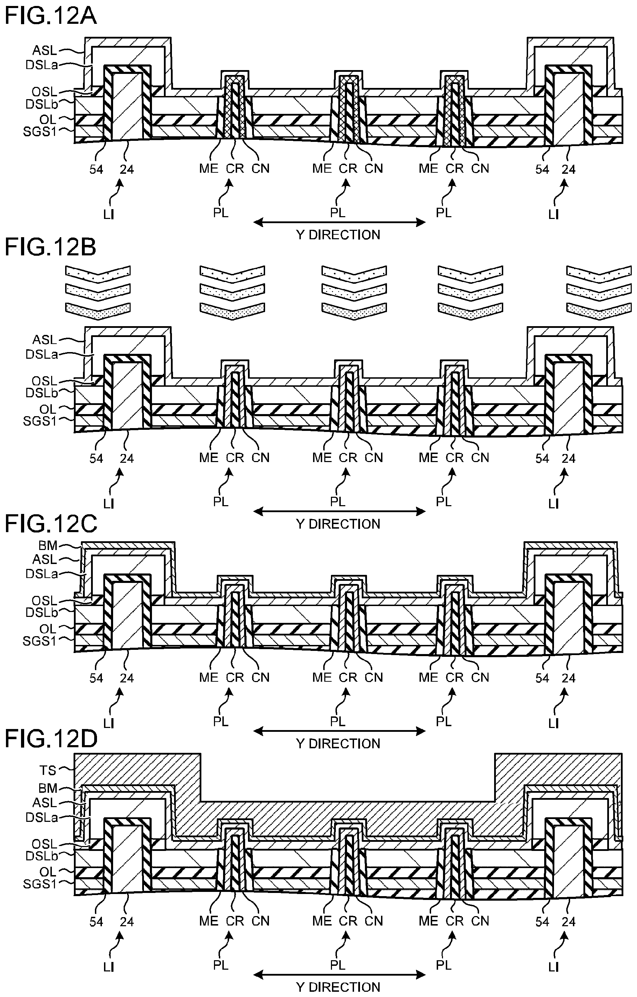

As illustrated in Fig. 12A, the auxiliary source line ASL covering the main source line DSLb exposed as a result of removal of the intermediate insulating layer OSL is formed. At this time, the auxiliary source line ASL is formed to also cover the upper end portions of the pillars PL protruding above the main source line DSLb and the stopper layer DSLa covering the upper end portions of the plate-like contacts LI.

The auxiliary source line ASL is formed as a non-doped amorphous silicon layer. The auxiliary source line ASL is used as a heat generation source that absorbs laser light in the annealing treatment with the laser light. Thereafter, in order to lower the contact resistance with the metal stacked on the auxiliary source line ASL, ion implantation (implant) of impurities that become N-type conductive such as phosphorus or arsenic may be performed on the surface of the auxiliary source line ASL. After the ion implantation, annealing or the like may be further performed to improve the conductivity of the auxiliary source line ASL.

As illustrated in Fig. 12B, the channel layers CN of the pillars PL covered with the auxiliary source line ASL are irradiated with laser light, and the channel layers CN are annealed by heat of the laser light. At this time, for example, laser light having a wavelength of 540 nm such as of a green laser can be used. When laser light having a wavelength of 540 nm is used, the channel layers CN can be heated to, for example, about 1100°C.

At the time of laser light irradiation, as described above, the auxiliary source line ASL absorbs the laser light and functions as a heat generation source. As a result, the auxiliary source line ASL is heated by the laser light, and the heat of the auxiliary source line ASL is further transmitted to the upper end portions of the channel layers CN of the pillars PL, and the channel layers CN are annealed.

As described above, by performing the annealing treatment using the laser light, the channel layers CN amorphized by doping with impurities are crystallized, and the N-type impurities doped in the channel layers CN can be activated. Note that, by such an annealing treatment or the like, a part or the whole of the auxiliary source line ASL that is originally an amorphous silicon layer or the like may be a polysilicon layer or the like, and a part or the whole of the stopper layer DSLa that is an amorphous silicon layer or the like by doping with impurities may be a polysilicon layer.

In addition, at this time, the laser light is also emitted to the formation region of the plate-like contacts LI. The plate-like contacts LI include the conductive layers 24 such as tungsten layers having a relatively large volume and extending in the X direction and the stacking direction of the stacked body LM. However, the conductive layers 24 of the plate-like contacts LI are covered with the insulating layers 54 such as silicon oxide layers having a lower thermal conductivity than the conductive layers 24. Therefore, heating of the conductive layers 24 by the laser light is suppressed.

As illustrated in Fig. 12C, the barrier metal BM is formed on the auxiliary source line ASL covering the main source line DSLb including the protruding portions of the pillars PL and the plate-like contacts LI.

As illustrated in Fig. 12D, the metal layer TS covering the barrier metal BM is further formed.

Thereafter, the insulating layer 60 is formed on the metal layer TS, and the plug PG penetrating the insulating layer 60 is formed. In addition, the electrode film EL connected to the plug PG in the insulating layer 60 is formed, and the insulating layer 70 covering the electrode film EL is formed. Further, an opening is provided in the insulating layer 70 to expose a part of the electrode film EL, thereby forming the pad region PD.

Thus, the semiconductor memory device 1 of the embodiment is manufactured.

### (Overview)

A semiconductor memory device such as a three-dimensional nonvolatile memory may be manufactured by forming peripheral circuits including transistors and the like and a stacked body including word lines, pillars PL, and the like on separate substrates and bonding these substrates.

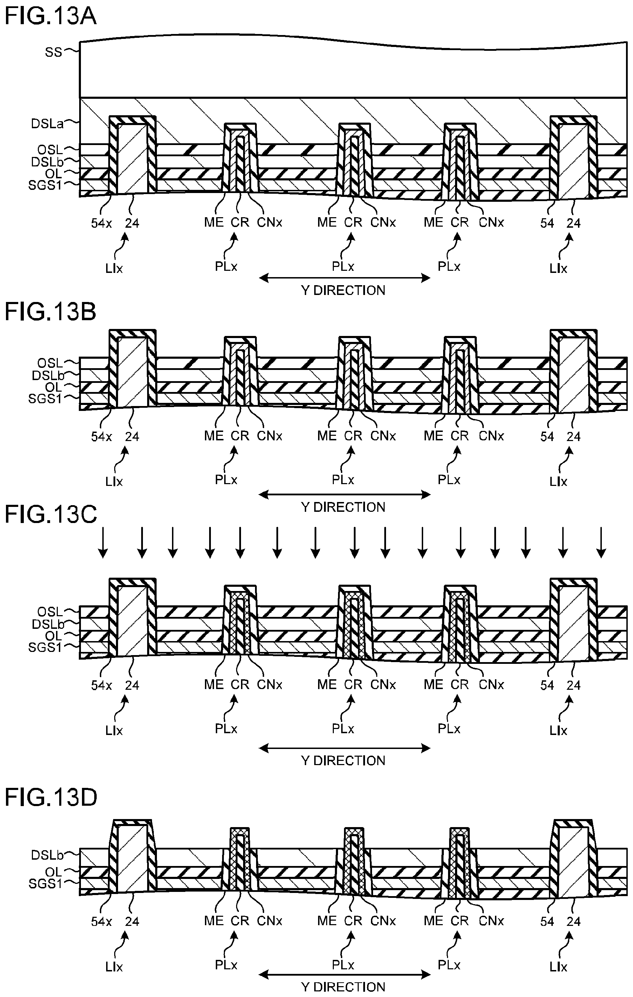

In addition, after the substrates are bonded to each other, various types of treatment may be performed from the back surface side of a support substrate that supports the stacked body or the like. The various types of treatment from the back surface side may include, for example, a treatment of doping the channel layer of the pillar with N-type impurities or the like and activating the channel layer by an annealing treatment using laser light. A state at this time is illustrated in Figs. 13A to 14C.

Figs. 13A to 14C are views illustrating a method for doping impurities into channel layers CNx of the semiconductor memory device according to a comparative example.

As illustrated in Fig. 13A, pillars PLx having channel layers CNx whose upper end portions protrude in a stopper layer DSLa and plate-like contacts LIx having insulating layers 54x covering conductive layers 24 whose upper end portions protrude in the stopper layer DSLa are formed on the upper surface of a semiconductor substrate where the peripheral circuits and the stacked body are bonded. As described above, the state of the semiconductor memory device of the comparative example in Fig. 13A corresponds to the state of Fig. 11A of the above-described embodiment.

As illustrated in Fig. 13B, a support substrate SS and the stopper layer DSLa are removed. At this time, in the comparative example, the entire stopper layer DSLa is removed. As a result, not only the upper end portions of the pillars PLx but also the upper end portions of the plate-like contacts LIx are exposed above an intermediate insulating layer OSL.

As illustrated in Fig. 13C, protruding portions of the channel layers CNx of the pillars PLx are doped with N-type impurities via memory layers ME. As a result, upper end portions of the channel layers CNx become amorphous semiconductor layers such as amorphous silicon layers.

As illustrated in Fig. 13D, the memory layers ME are removed from the upper end portions of the protruding pillars PLx, and the intermediate insulating layer OSL covering a main source line DSLb is removed. At this time, at the upper end portions of the plate-like contacts LIx, the insulating layers 54x covering the conductive layers 24 of the plate-like contacts LIx are exposed. Therefore, the insulating layers 54x of the plate-like contacts LIx are partially removed to be thinned together with the memory layers ME of the pillars PLx and the intermediate insulating layer OSL.

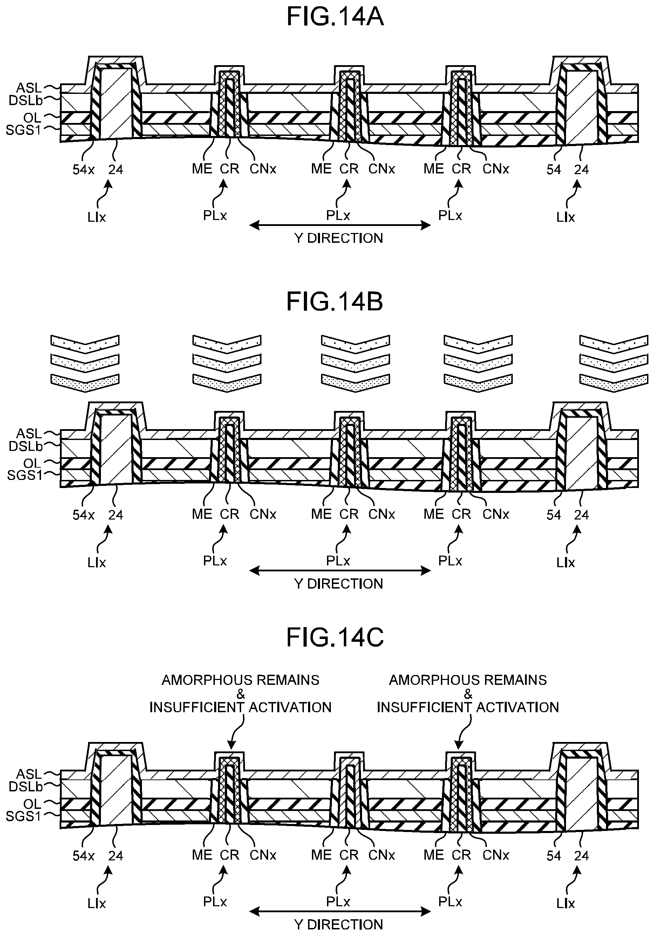

As illustrated in Fig. 14A, an auxiliary source line ASL entirely covering the main source line DSLb and the like is formed.

As illustrated in Fig. 14B, the channel layers CNx of the pillars PLx covered with the auxiliary source line ASL are irradiated with laser light to crystallize the channel layers CNx and to activate impurities in the channel layers CNx.

However, in the semiconductor memory device of the comparative example, the threshold voltage of the source-side select gates formed in the pillars PLx may vary among the plurality of pillars PLx. More specifically, in the pillars PLx adjacent to the plate-like contacts LIx, the threshold voltage of the select gate line may shift to a higher voltage side than a desired value.

The present inventor has conducted intensive studies to solve the above problem, and has found that heat by laser light is dissipated to the conductive layers 24 having a relatively large volume and included in the plate-like contacts LIx. As a result, it has been found that the temperature is not sufficiently raised by the laser light in the pillars PLx adjacent to the plate-like contacts LIx.

As illustrated in Fig. 14C, it is considered that the heat of the laser light is dissipated to the conductive layers 24 of the plate-like contacts LIx, so that the crystallization of the channel layers CNx becomes insufficient in the pillars PLx adjacent to the plate-like contacts LIx, and the impurities in the channel layers CNx are not sufficiently activated. As a result, it is presumed that the threshold voltage of the select gate line is shifted.

The present inventor has further studied and found that the degree of dissipation of heat of the laser light changes depending on the thickness of the insulating layers 54x of the plate-like contacts LIx.

With the semiconductor memory device 1 of the embodiment, the plate-like contacts LI have the protrusion portions penetrating the main source line DSLb and extending upward, and the protrusion portions are covered with the stopper layer DSLa disposed between the main source line DSLb and the auxiliary source line ASL and including a semiconductor as a main component.

In this manner, by leaving the stopper layer DSLa covering the upper end portions of the plate-like contacts LI, it is possible to suppress the insulating layers 54 of the plate-like contacts LI from becoming thin when the memory layers ME and the like at the upper end portions of the pillars PL are removed. Since the insulating layers 54 are maintained to have a sufficient thickness, it is possible to suppress the heat by the laser light from being dissipated from the conductive layers 24 of the plate-like contacts LI. Accordingly, it is possible to sufficiently crystallize the channel layers CN and sufficiently activate the impurities in the channel layers CN by the irradiation with the laser light, and it is possible to suppress the variation in the threshold voltage of the select gates STD formed in the pillars PL.

With the semiconductor memory device 1 of the embodiment, the plate-like contacts LI include the insulating layers 54 disposed on the upper surfaces and the sidewalls of the plate-like contacts LI, and the conductive layers 24 serving as the core materials having a higher thermal conductivity than the insulating layers 54. As described above, since the conductive layers 24 having a relatively large volume are insulated by the insulating layers 54 having a sufficient thickness, it is possible to suppress the heat by the laser light from being transmitted to the conductive layers 24 and being dissipated.

With the semiconductor memory device 1 of the embodiment, the semiconductor layer covering the upper end portions of the plate-like contacts LI includes the stopper layer DSLa in addition to the auxiliary source line ASL, and is thicker than the auxiliary source line ASL that is a semiconductor layer covering the upper end portions of the pillars PL and not including the stopper layer DSLa. As a result, it is possible to sufficiently activate the impurities in the channel layers CN by the irradiation with the laser light, and it is possible to suppress the variation in the threshold voltage of the select gates STD formed in the pillars PL.

By the method for manufacturing the semiconductor memory device 1 of the embodiment, before impurities are implanted into the channel layers CN of the pillars PL, a part of the stopper layer DSLa is removed to expose the one end portion of each of the pillars PL while leaving a portion covering one end portion of each of the plate-like contacts LI, whereby the channel layers CN can be sufficiently crystallized by the irradiation with the laser light, and the variation in the threshold voltage of the select gates STD formed in the pillars PL can be suppressed.

By the method for manufacturing the semiconductor memory device 1 of the embodiment, the main source line DSLb and the auxiliary source line ASL are stacked via the intermediate insulating layer OSL. As a result, the intermediate insulating layer OSL can be used as a stopper layer when the stopper layer DSLa is removed to expose the upper end portions of the pillars PL.

By the method for manufacturing the semiconductor memory device 1 of the embodiment, after impurities are implanted into the channel layers CN of the pillars PL, the intermediate insulating layer OSL is removed together with the memory layers ME. At this time, since the upper end portions of the plate-like contacts LI are protected by the stopper layer DSLa as described above, thinning of the insulating layers 54 of the plate-like contacts LI is suppressed.

By the method for manufacturing the semiconductor memory device 1 of the embodiment, the irradiation with the laser light includes irradiating the one end portion of each of the plate-like contacts LI covered with the stopper layer DSLa together with the channel layers CN of the pillars PL with the laser light. As described above, even in a case where the entire surface is irradiated with the laser light, the above-described configuration suppresses heat by the laser light from being transmitted to the conductive layers 24 and being dissipated.

By the method for manufacturing the semiconductor memory device 1 of the embodiment, the irradiation with the laser light includes crystallizing the channel layers CN of the pillars PL that have become amorphous by doping with the impurities. As described above, since the heat by the laser light is prevented from being dissipated by being transmitted to the conductive layers 24 of the plate-like contacts LI, the channel layers CN can be sufficiently crystallized, and the impurities can be activated.

Note that, in the embodiment described above, the semiconductor memory device 1 includes the stacked body LM having a two-tier structure in which two stacked bodies LMa and LMb are stacked up and down. However, the configuration of the stacked body is not limited to two tiers, and may be one tier or three tiers or more.

In addition, in the above-described embodiment, the staircase regions SR are disposed at both end portions in the X direction of the stacked body LM. However, the staircase region may be disposed at the central portion in the X direction of the stacked body, and the memory regions MR may be disposed at both end portions in the X direction.

In addition, in the above embodiment, the conductive layers 24 of the plate-like contacts LI include a metal such as tungsten, but instead of this, a semiconductor including Si or Ge may be used. The semiconductor including Si or Ge has higher thermal conductivity than the insulating layers 54. As described above, when the core material having a higher thermal conductivity than the insulating layers 54 is used for the plate-like contacts LI, the effect of the present embodiment can be obtained.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A semiconductor memory device (1) comprising:
a stacked body (LM) in which a plurality of conductive layers (WL, SGD, SGS) and a plurality of first insulating layers (OL) are alternately stacked one by one;
a plate-like portion (LI) that extends in the stacked body (LM) in a first direction intersecting a stacking direction of the stacked body (LM) and the stacking direction, and divides the stacked body (LM) in a second direction intersecting the first direction and the stacking direction;
a pillar (PL) that is disposed adjacent to the plate-like portion (LI) in the second direction and includes a semiconductor layer (CN) extending in the stacked body (LM) in the stacking direction;
a first layer (DSLb) that is disposed above the stacked body (LM) and includes a semiconductor as a main component; and
a second layer (ASL) that is disposed above the first layer (DSLb) and includes a semiconductor as a main component, wherein
the plate-like portion (LI) includes a protrusion portion penetrating the first layer (DSLb) and extending upward, and
the protrusion portion is covered with a third layer (DSLa) disposed between the first and second layers (DSLb, ASL) and including a semiconductor as a main component.

2. The semiconductor memory device (1) according to claim **1,** wherein
the third layer (DSLa) is selectively disposed at a position overlapping the plate-like portion (LI) in the stacking direction out of the plate-like portion (LI) and the pillar (PL).

3. The semiconductor memory device (1) according to claim 2, further comprising:
a second insulating layer (OSL) that is interposed between the first layer (DSLb) and the third layer (DSLa).

4. The semiconductor memory device (1) according to claim 1, wherein
the plate-like portion (LI) includes
a third insulating layer (54) disposed on an upper surface and a sidewall of the plate-like portion (LI), and
a core material (24) having a higher thermal conductivity than the third insulating layer (54).

5. The semiconductor memory device (1) according to claim 1, wherein
the first to third layers (DSLb, ASL, DSLa) include at least one of a polysilicon layer or an amorphous silicon layer, and
at least the third layer (DSLa) among the first to third layers (DSLb, ASL, DSLa) includes impurities of a first conductivity type.

6. A method for manufacturing a semiconductor memory device (1), comprising:
forming a stacked body (LM) in which a plurality of conductive layers (WL, SGD, SGS) and a plurality of first insulating layers (OL) are alternately stacked one by one on a first layer (DSLb) including a semiconductor as a main component, a plate-like portion (LI) penetrating the stacked body (LM) and the first layer (DSLb), extending in a first direction intersecting a stacking direction of the stacked body (LM), and dividing the stacked body (LM) in a second direction intersecting the first direction and the stacking direction, and a pillar (PL) disposed adjacent to the plate-like portion (LI) in the second direction, penetrating the stacked body (LI) and the first layer (DSLb), and including a semiconductor layer (CN) covered with a memory layer (ME); and
implanting impurities of a first conductivity type into the semiconductor layer (CN) protruding from the first layer (DSLb) and covered with the memory layer (ME), removing the memory layer (ME) at a portion protruding from the first layer (DSLb), covering the semiconductor layer (CN) protruding from the first layer (DSLb) with a second layer (ASL) including a semiconductor as a main component, and irradiating the semiconductor layer (CN) with laser light in the second layer (ASL); wherein
forming the plate-like portion (LI) and the pillar (PL) includes
causing the plate-like portion (LI) and the pillar (PL) penetrate the stacked body (LM) and the first layer (DSLb) to reach a third layer (DSLa) including a semiconductor as a main component, and
before implanting the impurities into the semiconductor layer (CN),
removing a part of the third layer (DSLa) to expose one end portion of the pillar (PL) while leaving a portion of the third layer (DSLa) that covers one end portion of the plate-like portion (LI).

7. The method for manufacturing a semiconductor memory device (1) according to claim 6, wherein
the first layer (DSLb) and the second layer (ASL) are stacked with a second insulating layer (OSL) interposed therebetween, and
the second insulating layer (OSL) is removed together with the memory layer (ME) after the impurities are implanted into the semiconductor layer (CN).

8. The method for manufacturing a semiconductor memory device (1) according to claim 6, wherein
the second layer (ASL) is formed over the first layer (DSLb) including the semiconductor layer (CN) and the plate-like portion (LI) covered with the third layer (DSLa).

9. The method for manufacturing a semiconductor memory device (1) according to claim 6, wherein
forming the plate-like portion (LI) includes
forming a third insulating layer (54) covering the one end portion and a sidewall of the plate-like portion (LI), and
forming a core material (24) having a higher thermal conductivity than the third insulating layer (54).

10. The method for manufacturing a semiconductor memory device (1) according to claim 6, wherein
irradiation with the laser light includes
irradiating the one end portion of the plate-like portion (LI) covered with the third layer (DSLa) with the laser light together with the semiconductor layer (CN).

11. The method for manufacturing a semiconductor memory device (1) according to claim 6, wherein
the stacked body (LM) including the pillar (PL) is formed above the first layer (DSLb) formed on a first substrate (SS), and
before removal of the third layer (DSLa),
a second substrate (SB) on which a peripheral circuit (CBA) contributing to an electrical operation of the pillar (PL) is formed is prepared, and
the first substrate (SS) and the second substrate (SB) are bonded, and the first substrate (SS) is removed.

12. The method for manufacturing a semiconductor memory device (1) according to claim 6, wherein
irradiation with the laser light includes
crystallizing the semiconductor layer (CN) that becomes amorphous by doping with the impurities.
